(19) Europäisches Patentamt

European Patent Office

Office européen des brevets

(11) **EP 4 528 814 B1**

(12) **EUROPEAN PATENT SPECIFICATION**

(45) Date of publication and mention
of the grant of the patent:
**24.06.2026 Bulletin 2026/26**

(21) Application number: **24201899.2**

(22) Date of filing: **23.09.2024**

(51) International Patent Classification (IPC):
*H10W 44/00* (2026.01)    *H10W 72/00* (2026.01)
*H10W 70/05* (2026.01)    *H10W 70/65* (2026.01)
*H10W 70/685* (2026.01)    *H10W 70/63* (2026.01)

(52) Cooperative Patent Classification (CPC):
**H10W 44/00; H10W 72/00;** H10W 70/05;
H10W 70/095; H10W 70/635; H10W 70/65;
H10W 70/685

(54) **SEMICONDUCTOR DEVICE**

HALBLEITERANORDNUNG

DISPOSITIF SEMI-CONDUCTEUR

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **22.09.2023 US 202363584515 P**

(43) Date of publication of application:
**26.03.2025 Bulletin 2025/13**

(73) Proprietor: **MEDIATEK INC.
Hsinchu City 30078 (TW)**

(72) Inventor: **Chen, Nan-Jang
30078 Hsinchu City (TW)**

(74) Representative: **Wright, Howard Hugh Burnby
Withers & Rogers LLP
2 London Bridge
London SE1 9RA (GB)**

(56) References cited:
**US-A1- 2011 248 800    US-A1- 2016 013 536
US-A1- 2017 179 050    US-A1- 2023 170 290**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

BACKGROUND OF THE INVENTION

Field of the Invention

The invention relates in general to a semiconductor device.

Description of the Related Art

Interfaces with discontinuous impedances will produce signal reflections. The impedance mismatch will lead to signal reflection and attenuation, which is manifested in reverse signal transmission, signal attenuation, and signal distortion. If there is an impedance mismatch at one end of the transmission line, part of the signal will be reflected back. This will affect the power transfer and signal quality of the signal in the transmission line, and also cause echo interference.

US 2023/170290 discloses a semiconductor package comprising a redistribution substrate and a semiconductor chip on the redistribution substrate.

US 2011/248800 discloses a filter with a planar transmission line and a combined via structure connected to both ends of the planar transmission line. The planar transmission line and the combined via structure are disposed in the same multilayer board, and the combined via structure comprises two working parts. The first working part comprises a segment of signal via and a plurality of segments of ground vias surrounding the signal via, and the second working part comprises a segment of the same signal via, a plurality of segments of the same ground vias, smooth conductive plate and corrugated conductive plate. The smooth conductive plate and the corrugated conductive plate are connected to the signal via. The second working part comprises a segment of the same signal via, a plurality of segments of the same ground vias and corrugated conductive plate. The corrugated conductive plate is connected to the signal via.

SUMMARY OF THE INVENTION

According to an embodiment of the present disclosure, a semiconductor device is provided. The semiconductor device includes a first conductive layer and second conductive layer. The second conductive layer is disposed opposite to the first conductive layer. One of the first conductive layer and the second conductive layer includes a first grounding net and a first signal ball-pad. The first grounding net has a first void, and the first signal ball-pad is disposed in the first void. The first signal ball-pad has a first pad diameter, the first void has a first ground void diameter, and a ratio of the first ground void diameter to the first pad diameter is equal to or greater than 1.2.

According to another embodiment of the present disclosure, a semiconductor device is provided. The semiconductor device includes a first conductive layer and second conductive layer. The second conductive layer is disposed opposite to the first conductive layer. One of the first conductive layer and the second conductive layer includes a first grounding net and a first signal ball-pad. The first signal ball-pad has a first ball-pad diameter, the first signal ball-pad is spaced from a lateral wall of the first void by a first minimum interval, and the first minimum interval is greater than 0.1 times of the first ball-pad diameter.

The above and other aspects of the disclosure will become better understood with regard to the following detailed description of the preferred but non-limiting embodiment (s). The following description is made with reference to the accompanying drawings.

BRIEF DESCRIPTION OF THE DRAWINGS

FIG. 1 illustrates a schematic diagram of a semiconductor device according to an embodiment of the present disclosure;

FIG. 2A illustrates a schematic diagram of a first conductive layer of the semiconductor device in FIG. 1;

FIG. 2B illustrates a schematic diagram of a second conductive layer of the semiconductor device in FIG. 1;

FIG. 2C illustrates a schematic diagram of the first conductive layer in FIG. 2A and the second conductive layer in FIG. 2B overlapping;

FIG. 2D illustrates a schematic diagram of a cross-sectional view of the structure in FIG. 2C along a direction 2D-2D';

FIG. 2E illustrates a schematic diagram of a cross-sectional view of the structure in FIG. 2C along a direction 2E-2E';

FIG. 3 illustrates a schematic diagram of a relationship between time vs. voltage of groups 1 to 5 in Table 1;

FIG. 4 illustrates a schematic diagram of a first conductive layer according to another embodiment of the present disclosure;

FIG. 5 illustrates a schematic diagram of a top view of a semiconductor device 300 according to another embodiment of the present disclosure;

FIG. 6A illustrates a schematic diagram of a T-coil circuit according to an embodiment of the present disclosure;

FIG. 6B illustrates a schematic diagram of a coil of the T-coil circuit in FIG. 6A;

FIG. 7 illustrates a schematic diagram of a T-coil circuit 20 according to another embodiment of the present disclosure; and

FIG. 8 illustrates a schematic diagram of a semiconductor system 1 according to another embodiment of the present disclosure.

DETAILED DESCRIPTION OF THE INVENTION

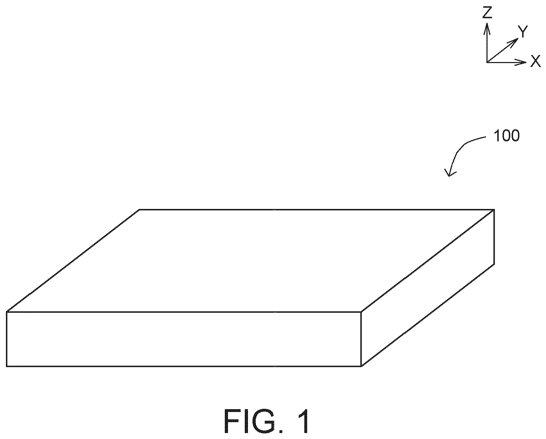

Referring to FIG. 1, FIG. 1 illustrates a schematic diagram of a semiconductor device 100 according to an embodiment of the present disclosure. The semiconductor device 100 is, for example, a semiconductor chip, a silicon interposer, a substrate, a semiconductor package, a circuit board (for example, a printed circuit board), etc. The semiconductor device 100 includes at least one conductive layer, wherein the conductive layer may reduce a capacitance for increasing an impedance (for example, a differential impedance). For example, the differential impedance may be increased from 50 ohm ($\Omega$) to 85 $\Omega$, depending on the signal ball-pad dimensions.

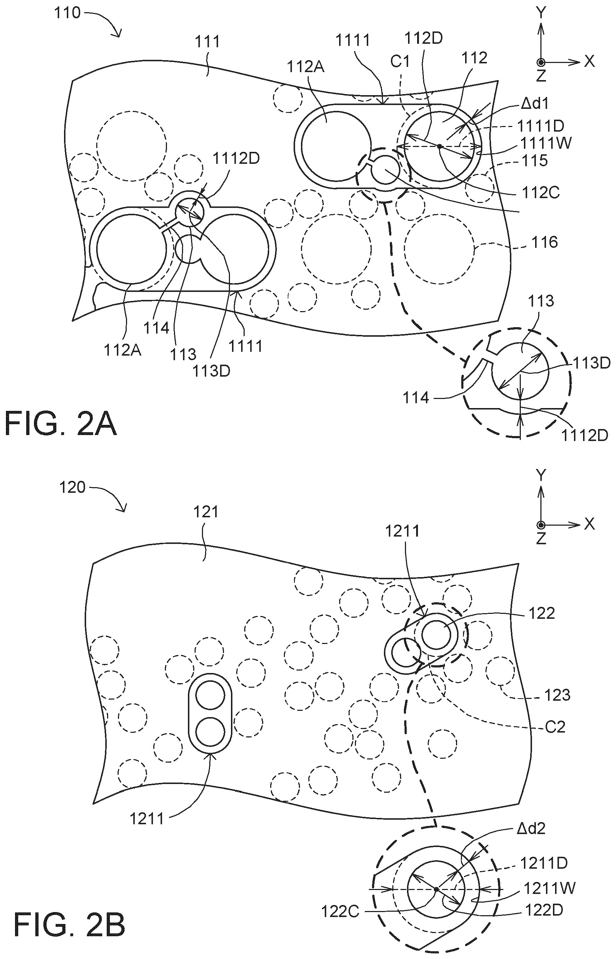

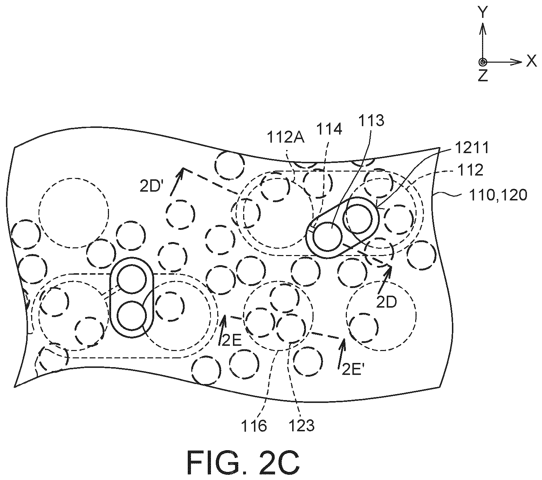

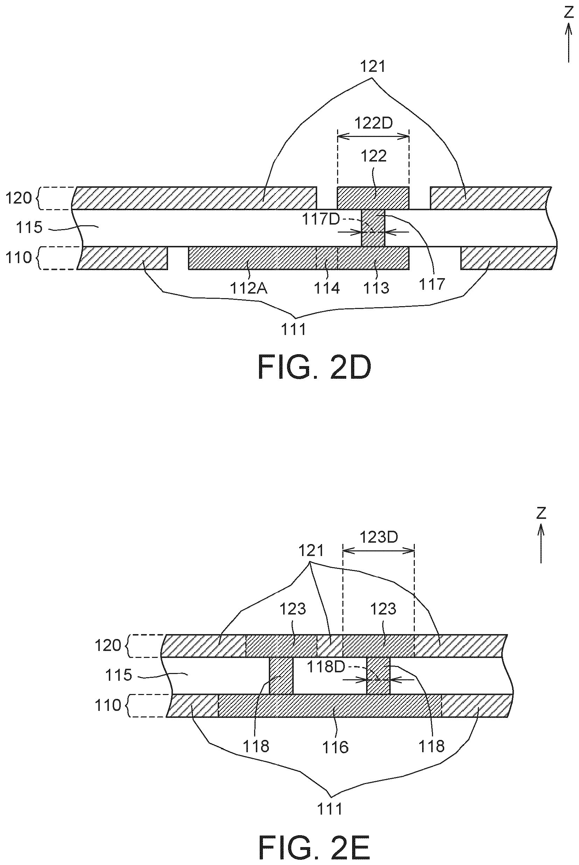

Referring to FIGS. 2A to 2E, FIG. 2A illustrates a schematic diagram of a first conductive layer of the semiconductor device 100 in FIG. 1, FIG. 2B illustrates a schematic diagram of a second conductive layer of the semiconductor device 100 in FIG. 1, FIG. 2C illustrates a schematic diagram of the first conductive layer 110 in FIG. 2A and the second conductive layer 120 in FIG. 2B overlapping, FIG. 2D illustrates a schematic diagram of a cross-sectional view of the structure in FIG. 2C along a direction 2D-2D', and FIG. 2E illustrates a schematic diagram of a cross-sectional view of the structure in FIG. 2C along a direction 2E-2E'.

As illustrated in FIG. 2A, the first conductive layer 110 includes a first grounding net 111, at least one first signal ball-pad 112, at least one first signal via-pad 113, at least one first signal trace 114, at least one first grounding via-pad 115 and at least one first grounding ball-pad 116.

As illustrated in FIG. 2A, the first grounding net 111 has a first ground void 1111. At least one the first signal ball-pad 112 is disposed within the first ground void 1111, where there is no conductive material existing in the void region to connect the signal pad and grounding net. The first signal ball-pad 112 has a first ball-pad diameter 112D, and the first ground void 1111 has a first ground void diameter 1111D, wherein a ratio of the first ground void diameter 1111D to the first ball-pad diameter 112D is equal to or greater than 1.2, for example. As a result, the capacitance between the first signal ball-pad 112 and the first grounding net 111 may be reduced for increasing the impedance. For example, the differential impedance may be increased from 50 ohm ($\Omega$) to 85 $\Omega$, depending on the signal ball-pad dimensions. The first ground void diameter 1111D is a diameter of an approximate circle C1 as close to a lateral wall 1111W of the first ground void 1111 as possible. The approximate circle C1 surrounds the first signal ball-pad 112, and a circle center of the approximate circle C1 overlap a center 112C of the first signal ball-pad 112, for example.

In an embodiment, the first signal ball-pad 112 is spaced from a lateral wall 1111W of the first ground void 1111 by a first minimum interval $\Delta d1$, and the first minimum interval $\Delta d1$ is greater than 0.1 times of the first ball-pad diameter 112D (that is, $\Delta d1 \geq 0.1 \times 112D$). As a result, the capacitance between the first signal ball-pad 112 and the first grounding net 111 may be reduced for increasing the impedance.

As shown in formula (1) below, $Z_{diff}$ is the differential impedance, $C_S$ is a self-capacitance, $C_m$ is a mutual capacitance, $L_S$ is a self-inductance, and $L_m$ is a mutual inductance. According to formula (1), the differential impedance $Z_{diff}$ is proportional to the capacitance. In other words, when the capacitance between the first signal ball-pad 112 and the first grounding net 111 reduces, the impedance is increased. Through the ratio design of the conductive layer in the present embodiment, it may achieve the continuous impedance with less reflection.

$$Z_{diff} = 2 \times \sqrt{\frac{L_s - L_m}{c_s \mp c_m}} \cdots (1)$$

As illustrated in FIG. 2A, the first conductive layer 110 is, for example, the bottom conductive layer (for example, the bottommost conductive layer) of the semiconductor device 100. The first signal ball-pad 112 may be exposed from the semiconductor device 100 for connecting a signal contact, for example, a solder ball, solder paste, a bump, a pillar, etc. The first signal via-pad 113, the first signal trace 114 and a second signal ball-pad 112A may be disposed within the first void 1111, wherein the first signal trace 114 connects the second signal ball-pad 112A with the first signal via-pad 113. The first grounding via-pad 115 may connect a grounding via (not illustrated in FIG. 2A). The first grounding ball-pad 116 may be exposed from the semiconductor device 100 for connecting a grounding contact, for example, a solder ball, solder paste, a bump, a pillar, etc. The first signal via-pad 113 has a first via-pad diameter 113D, and the first ground void 1111 has a second ground void diameter 1112D, wherein a ratio of the second ground void diameter 1112D to the first via-pad diameter 113D is equal to or greater than 1.2, for example. As a result, the capacitance between the first signal via-pad 113 and the first grounding net 111 may be reduced for increasing the impedance.

In an embodiment, the first and second signal ball-pads 112 and 112A, the first signal via-pad 113 and the first signal trace 114 may be for used as signal transmission set or signal receiving set. In an embodiment, the first conductive layer 110 may include at least one signal transmission set and/or at least one signal receiving set.

As illustrated in FIG. 2B, in an embodiment, the second conductive layer 120 is disposed above the first conductive layer 110. The second conductive layer 120 includes a second grounding net 121, at least one second signal via-pad 122 and at least one second grounding via-pad 123.

As illustrated in FIG. 2B, the second grounding net 121 has a second ground void 1211, wherein the second signal via-pad 122 is disposed within the second ground void 1211. The second ground void 1211 has a third ground void diameter 1211D, the second signal via-pad 122 has a second via-pad diameter 122D, and a ratio of the third ground void diameter 1211D to the second via-pad diameter 122D is equal to or greater than 1.2, for example. As a result, the capacitance between the second grounding net 121 and the second signal via-pad 122 may reduce for increasing the impedance. The second via-pad diameter 122D is a diameter of an approximate circle C2 as close to a lateral wall 1211W of the second ground void 1211 as possible. The approximate circle C2 surrounds the second signal via-pad 122, and a circle center of the approximate circle C2 overlap a center 122C of the second signal via-pad 122, for example.

In an embodiment, the second signal via-pad 122 is spaced from the lateral wall 1211W of the second ground void 1211 by a second minimum interval $\Delta d2$, and the second minimum interval $\Delta d2$ is greater than 0.1 times of the second via-pad diameter 122D (that is, $\Delta d2 \geq 0.1 \times 122D$). As a result, the capacitance between the second signal via-pad 122 and the second grounding net 121 may be reduced for increasing the impedance.

In an embodiment, a ratio of the third ground void diameter 1211D (as illustrated in FIG. 2B) of the second ground void 1211 in the second conductive layer 120 to the first ball-pad diameter 112D (as illustrated in FIG. 2A) of the first signal ball-pad 112 in the first conductive layer 110 may be greater than 1.0. For example, the first ball-pad diameter 112D would be 280 $\mu m$ or 240 $\mu m$. The second via-pad diameter 122D would be 50 $\mu m$, 80 $\mu m$, 100 $\mu m$, or 120 $\mu m$ depending on the dimension of semiconductor device.

As illustrated in FIGS. 2C and 2D, the second conductive layer 120 may be disposed above the first conductive layer 110. Two adjacent conductive layers may be separated by a dielectric layer. For example, the second conductive layer 120 and the first conductive layer 110 may be separated by a dielectric layer 115. The second conductive layer 120 may be electrically connected with the first conductive layer 110 by at least one signal via 117. Furthermore, the signal via 117 connects the second signal via-pad 122 in the second conductive layer 120 with the first signal via-pad 113 in the first conductive layer 110. The signal via 117 has a via diameter 117D, and a ratio of the via diameter 117D to the second via-pad diameter 122D may equal to 0.5, even less or greater. For example, the via diameter 117D is, for example, 50 micrometers ($\mu m$), and the second via-pad diameter 122D is, for example, 100 $\mu m$.

As illustrated in FIGS. 2B and 2C, the first ball-pad diameter 112D is greater than the second via-pad diameter 122D. As a result, the first signal ball-pad 112 may provide a larger area for receiving the signal contact, for example, a solder ball, solder paste, a bump, a pillar, etc.

As illustrated in FIGS. 2C and 2E, the second conductive layer 120 may be electrically connected with the first conductive layer 110 by at least one grounding via 118. Furthermore, the grounding via 118 connects the second grounding via-pad 123 in the second conductive layer 120 with the first grounding ball-pad 116 in the first conductive layer 110. The grounding via 118 has a via diameter 118D, and the second grounding ball-pad 123 has a second pad diameter 123D, wherein a ratio of the via diameter 118D to the second pad diameter 123D may equal to 0.5, even less or greater. For example, the via diameter 118D is, for example, 50 micrometers ($\mu m$), and the second pad diameter 123D is, for example, 100 $\mu m$.

As illustrated in FIG. 2C, in an embodiment, at least one portion of the second ground void 1211 overlap at least one portion of the first signal ball-pad 112 in Z-axis, and accordingly it may reduce the capacitance for increasing the impedance.

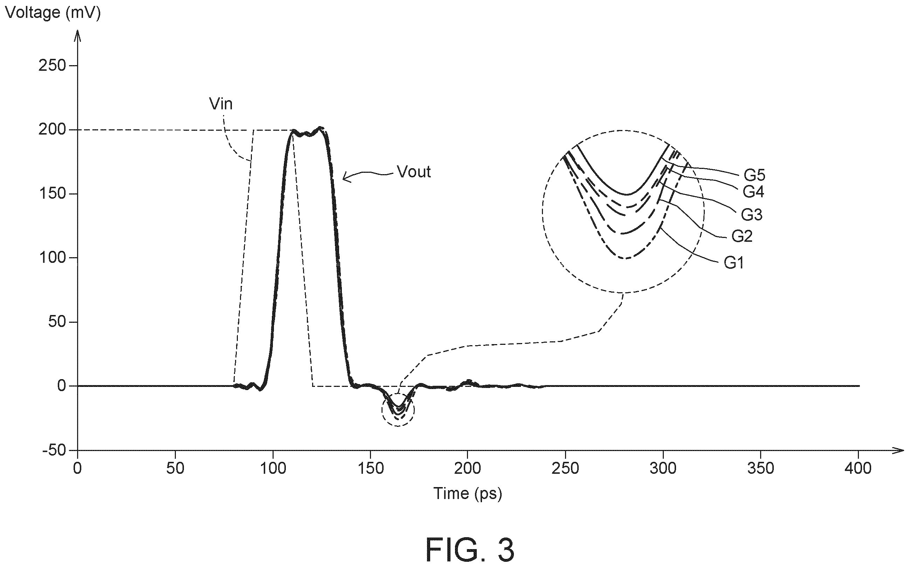

Referring to FIG. 3, FIG. 3 illustrates a schematic diagram of a relationship between time vs. voltage of groups 1 to 5 in Table 1. The relationship between time vs. voltage may be obtained by using SBR (single-bit response) simulation. In group 1, there are two conductive layers (Layer 3 and Layer 4) use the design of the ratio as started above, wherein a ground void diameter of at least one void in Layer 4 is 290 $\mu$m, and a ground void diameter of at least one void in Layer 3 is 240 $\mu$m. In group 2, there are three conductive layers (Layer 2, Layer 3 and Layer 4) use the design of the ratio as started above, wherein a ground void diameter of at least one void in Layer 4 is 290 $\mu$m, a ground void diameter of at least one void in Layer 3 is 290 $\mu$m, and a ground void diameter of at least one void in Layer 2 is 290 $\mu$m. In group 3, there are four conductive layers (Layer 1, Layer 2, Layer 3 and Layer 4) use the design of the ratio as started above, wherein a ground void diameter of at least one void in Layer 4 is 290 $\mu$m, a ground void diameter of at least one void in Layer 3 is 290 $\mu$m, a ground void diameter of at least one void in Layer 2 is 290 $\mu$m and a ground void diameter of at least one void in Layer 1 is 290 $\mu$m. In group 4, there are four conductive layers (Layer 1, Layer 2, Layer 3 and Layer 4) use the design of the ratio as started above, wherein a ground void diameter of at least one void in Layer 4 is 340 $\mu$m, a ground void diameter of at least one void in Layer 3 is 290 $\mu$m, a ground void diameter of at least one void in Layer 2 is 290 $\mu$m and a ground void diameter of at least one void in Layer 1 is 290 $\mu$m. In group 5, there are four conductive layers (Layer 1, Layer 2, Layer 3 and Layer 4) use the design of the ratio as started above, wherein a ground void diameter of at least one void in Layer 4 is 390 $\mu$m, a ground void diameter of at least one void in Layer 3 is 290 $\mu$m, a ground void diameter of at least one void in Layer 2 is 290 $\mu$m and a ground void diameter of at least one void in Layer 1 is 290 $\mu$m. The Layer 4 in group 5 has the greater the ground void diameter than that of Layer 4 in group 4. The Layer 4 is, for example, the bottommost conductive layer of the semiconductor device, and Layers 4 to 1 are disposed in order from bottom to top.

Table 1

| Group | ground void diameter ($\mu$m) | | | |
| --- | --- | --- | --- | --- |
| | Layer 1 | Layer 2 | Layer 3 | Layer 4 |
| 1 | Retain | Retain | 240 | 290 |
| 2 | Retain | 290 | 290 | 290 |
| 3 | 290 | 290 | 290 | 290 |
| 4 | 290 | 290 | 290 | 340 |
| 5 | 290 | 290 | 290 | 390 |

As illustrated in FIG. 3, the curves G1 to G5 present the output voltage Vout from the first signal ball-pad 112 (for example, in Layer 4) in groups 1 to 5 respectively. The input pulsed voltage Vin is input to a contact (for example, bump) of a chip , through the trace and connecting to the signal ball-pad (not illustrated) which may be disposed outside the semiconductor device 100 or inside the semiconductor device 100. The input pulsed voltage Vin is 0.2 v with 42.8 picosecond (ps) of one unit interval (UI), 10 ps of rise time and 10 ps of fall time, for example. The first reflections of groups 1 to 5 are shown in an enlarged diagram of FIG. 3.

As illustrated in FIG. 3, the less the signal reflection, the better the impedance continuity is. The curve G5 presents the minimum signal reflection, and the curve G1 presents the maximum signal reflection. A ratio of the curve G1 to the curve G5 in 1$^{st}$ reflection is -37.7 % (for example, calculation formula: $1 - \dfrac{-24.7 - (-15.4)\,mV}{-24.7\,mV}$ ). It can be seen that the impedance continuity may be obviously improved by the size or ration design of the ground void and the signal ball-pad as stated above.

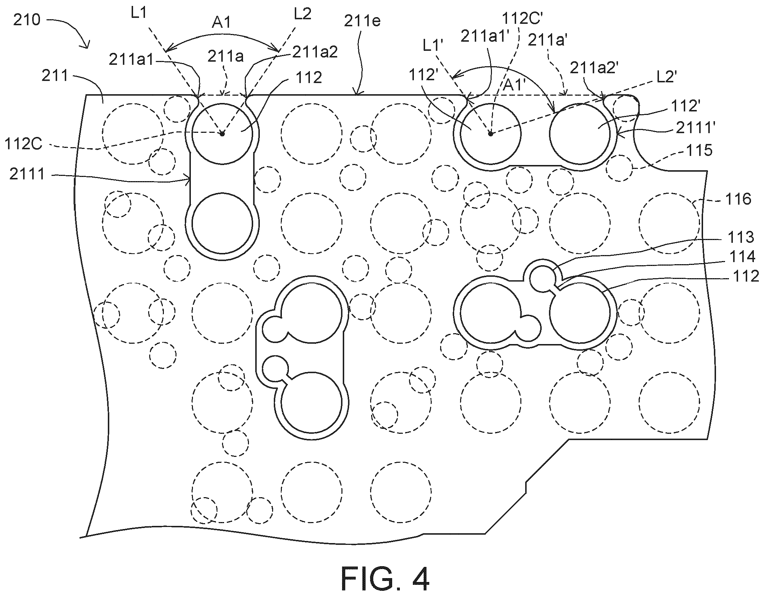

Referring to FIG. 4, FIG. 4 illustrates a schematic diagram of a first conductive layer 210 according to another embodiment of the present disclosure. The first conductive layer 210 may replace the first conductive layer 110 in FIG. 2A. The first conductive layer 210 includes a first grounding net 211, at least one first signal ball-pad 112, at least one first signal via-pad 113, at least one first signal trace 114, at least one first grounding via-pad 115 and at least one first grounding ball-pad 116. The first grounding net 211 has a boundary 211e, wherein the first void 2111 extends to the boundary 211e to form an opening 211a. In the present embodiment, the opening 211a exposes one first signal ball-pad 112. There is a first connection line L1 of the center 112C of the first signal ball-pad 112 and a first edge 211a1 of the opening 211a, and There is a second connection line L2 of the center 112C of the first signal ball-pad 112 and a second edge 211a2 of the opening 211a, wherein an angle A1 included between the first connection line L1 and the second connection line L2 may be equal to or greater than 60 degrees. As a result, the first conductive layer 210 may reduce the capacitance for increasing the impedance (for example, the differential impedance). For example, the impedance may be increased from 68 $\Omega$ to 73 $\Omega$.

As illustrated in FIG. 4, the first ground void 2111' exposes an opening 211a'. In the present embodiment, the opening 211a' exposes a plurality of the first signal ball-pad 112'. There is a first connection line L1' of the center 112C' of the first signal ball-pad 112' and a first edge 211a1' of the opening 211a', and there is a second connection line L2' of the center 112C' of the first signal ball-pad 112' and a second edge 211a2' of the opening 211a', wherein an angle A1' included between the first connection line L1' and the second connection line L2' may be equal to or greater than 60 degrees. As a result, the first conductive layer 210 may reduce the capacitance for increasing the impedance (for example, the differential impedance). For example, the impedance may be increased from 68 $\Omega$ to 73 $\Omega$.

In another embodiment, the first ground void 2111 having the opening 211a and the opening 211a' may be applied to the first grounding net 111 in FIG. 2A.

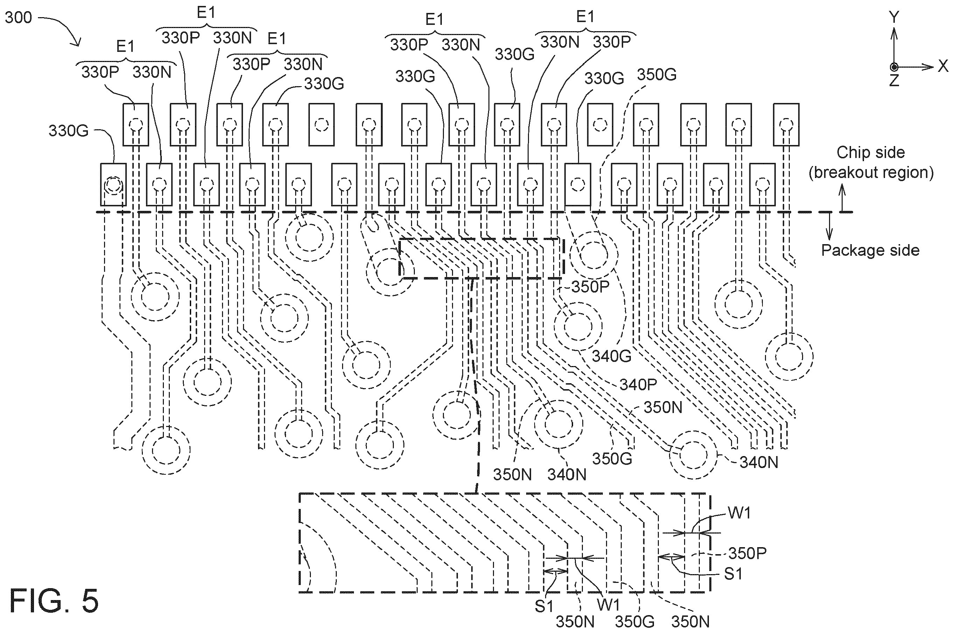

Referring to FIG. 5, FIG. 5 illustrates a schematic diagram of a top view of a semiconductor device 300 according to another embodiment of the present disclosure. The semiconductor device 300 includes a chip and a package, and the chip may be stacked to the package.

As illustrated in FIG. 5, the chip includes a plurality of grounding contacts 330G, a plurality of negative electrode contacts 330N and a plurality of positive electrode contacts 330P. One electrode contact 330N and the positive electrode contact 330P construct one electrode set E1. In an embodiment, in a region, one electrode set E1 may be located between two grounding contacts 330G, and in another region, a plurality of the electrode sets E1 may be located between two grounding contacts 330G.

As illustrated in FIG. 5, the package includes a plurality of grounding contacts 340G, a plurality of negative electrode contacts 340N and a plurality of positive electrode contacts 340P, a plurality of grounding traces 350G, a plurality of negative electrode traces 350N and a plurality of positive electrode traces 350P.

As illustrated in FIG. 5, the grounding trace 350G connects the grounding contact 330G through the grounding contacts 340G. The negative electrode trace 350N connects the negative electrode contact 330N through the negative electrode contact 340N. The positive electrode trace 350P connects the positive electrode contact 330P through the positive electrode contact 340P. In an embodiment, the trace may be a SerDes (Serializer/Deserializer) trace.

As illustrated in FIG. 5, in the present embodiment, the positive electrode contact 330P and the negative electrode contact 330N are staggered to each other in a first direction and a second direction different from the first direction, wherein the first direction is, for example, parallel to X-axis, and the second direction is, for example, parallel to Y-axis. As a result, the chip size can be reduced with the staggered electrode contacts.

As illustrated in FIG. 5, each trace has a trace width W1, and the trace widths W1 are substantially equal in the breakout region and out of breakout region as shown in FIG. 5, for example. There is a trace space S1 between two adjacent traces, wherein the trace spaces S1 are substantially equal, for example. The substantially equal trace widths W1 and/or the substantially equal spaces S1 may achieve the continuous impedance with less reflection.

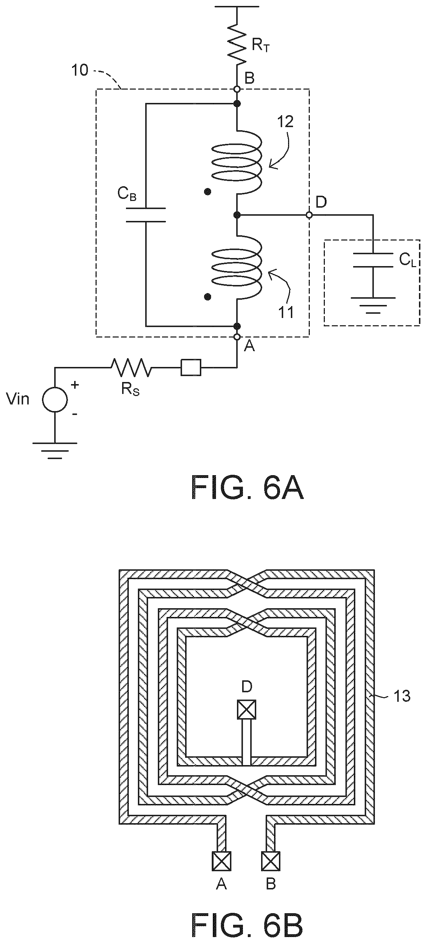

Referring to FIGS. 6A and 6B, FIG. 6A illustrates a schematic diagram of a T-coil circuit 10 according to an embodiment of the present disclosure, and FIG. 6B illustrates a schematic diagram of a coil 13 of the T-coil circuit 10 in FIG. 6A. The T-coil circuit 10 may be disposed in the chip to counteract the effects of parasitic capacitances ($C_L$) including electrostatic discharge (ESD) protection circuits, input/output (I/O) pads, and others.

As illustrated in FIG. 6A, the T-coil circuit 10 includes a first inductor 11 and a second inductor 12, wherein a first inductance value $L_1$ of the first inductor 11 and a second inductance value $L_2$ of the second inductor 12 satisfy the following formulas (2a) to (2b). In formulas (2a) to (2b), $\zeta$ is a damping factor of a transfer function, $C_L$ is a load capacitance, $C_B$ is a bridge capacitor, and $R_T$ is a termination resistance.

$$L_1 = L_2 = \frac{C_L R_T^2}{4}\left(1 + \frac{1}{4\zeta^2}\right)\ldots(2a)$$

$$C_B = \frac{C_L}{16\zeta^2}\ldots(2b)$$

As illustrated in FIGS. 6A and 6B, a coil 13 forming the first inductor 11 and the second inductor 12 may spirally extend from a first terminal A to a second terminal B, wherein a third terminal D connects a line between the first inductor 11 and the second inductor 12 with the load capacitance $C_L$.

The T-coil circuit 10 is a special form of an inductive peaking circuit that will extend an amplifier's bandwidth and speed up the output signal rise-time. The circuit uses a coupled inductor and a small bridging capacitor. The T-coil circuit 10 may double the bandwidth of an amplifier. The inductor as steers an input current into the load capacitance $C_L$, so it charges up more rapidly. The small bridging capacitor ensures that the input impedance of the T-coil is constant and resistive.

As shown in Table 2 below, the impedance $Z_{in}$ is equal to a termination resistance $R_T$, and the inductance value of the coil 13 is proportional to value of $R_T^2$ (or proportional to the impedance Zin). The less the termination resistance $R_T$ is, the less the occupied area of the coil 13 is. In other words, compared to the differential impedance (=$2R_T$) being 100 $\Omega$, the occupied area of the coil 13 is less when the differential impedance (=$2R_T$) being 80 $\Omega$ (for example, reduced by 36 %).

Table 2

| $R_T$=$Z_{in}$ ($\Omega$) | $R_T^2$ | L (nH) | ratio |
|---|---|---|---|
| 60.0 | 3,600 | 1.44 | 44% |
| 50.0 | 2,500 | 1.00 | 0 |
| 45.0 | 2,025 | 0.81 | -19% |
| 42.5 | 1,806 | 0.72 | -28% |
| 40.0 | 1,600 | 0.64 | -36% |
| 37.5 | 1,406 | 0.56 | -44% |
| 35.0 | 1,225 | 0.49 | -51% |

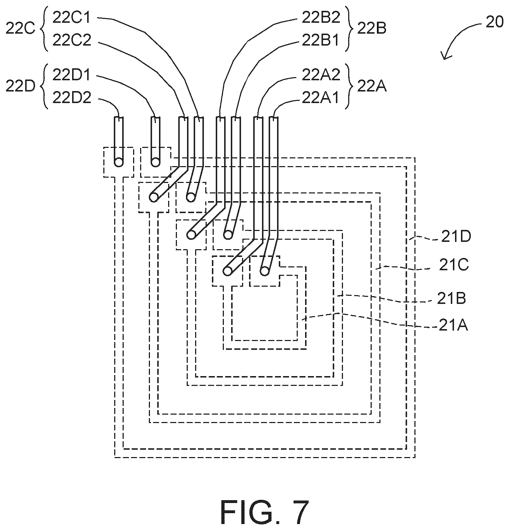

Referring to FIG. 7, FIG. 7 illustrates a schematic diagram of a T-coil circuit 20 according to another embodiment of the present disclosure. The T-coil circuit 20 may be disposed in or on a chip, a silicon interposer, a substrate, a package or a circuit board.

As illustrated in FIG. 7, the T-coil circuit 20 includes a first coil 21A, a second coil 21B, a third coil 21C and a fourth coil 21D, a first conductive trace set 22A, a second conductive trace set 22B, a third conductive trace set 22C and a fourth conductive trace set 22D. The first conductive trace set 22A includes a first trace 22A1 and a second trace 22A2, and the first trace 22A1 and the second trace 22A2 are connected with two terminal of the first coil 21A. The second conductive trace set 22B includes a first trace 22B1 and a second trace 22B2, and the first trace 22B1 and the second trace 22B2 are connected with two terminal of the second coil 21B. The third conductive trace set 22C includes a first trace 22C1 and a second trace 22C2, and the first trace 22C1 and the second trace 22C2 are connected with two terminal of the third coil 21C. The fourth conductive trace set 22D includes a first trace 22D1 and a second trace 22D2, and the first trace 22D1 and the second trace 22D2 are connected with two terminal of the fourth coil 21D.

As illustrated in FIG. 7, the first conductive trace set 22A may be electrically connected with the first coil 21A through a first controller (not illustrated). The second conductive trace set 22B may be electrically connected with the second coil 21B through a second controller (not illustrated). The third conductive trace set 22C may be electrically connected with the third coil 21C through a third controller (not illustrated). The fourth conductive trace set 22D may be electrically connected with the fourth coil 21D through a fourth controller (not illustrated). The first controller, the second controller, the third controller and the fourth controller include, for example, MUX/Selector or MOS switch.

In the present embodiment, like using at least one bond wire (not illustrated) to adjust spiral inductors (namely, the first coil 21A, the second coil 21B, the third coil 21C and the fourth coil 21D) in the package (for example, a BGA package), the segmented spiral inductors in the T-coil network would be selected through at least one controller (including, for example, MUX/Selector or MOS switch) to match the dedicated termination ($R_T$) or compensate the process variation.

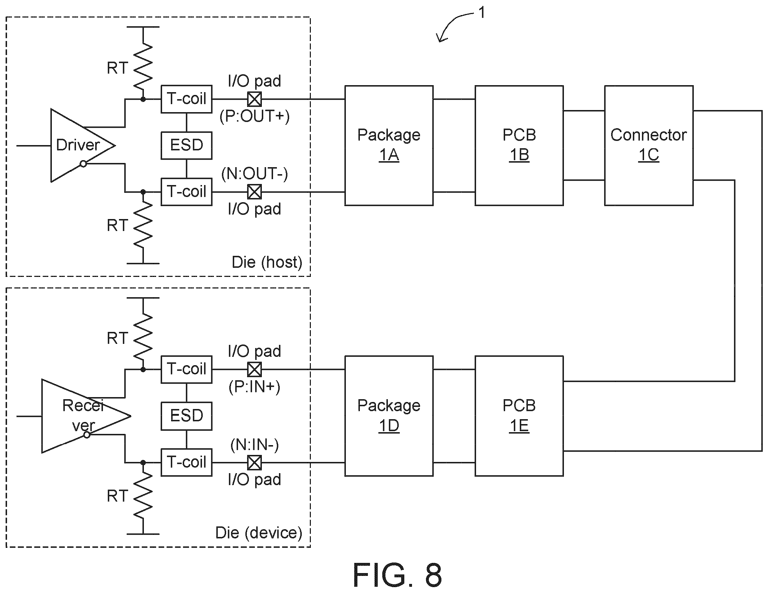

Referring to FIG. 8, FIG. 8 illustrates a schematic diagram of a semiconductor system 1 according to another embodiment of the present disclosure. The semiconductor system 1 includes a package 1A, a package 1B, a connector 1C, a PCB 1D, a PCB 1E, a driver and a receiver. The driver may transmit a signal to the receiver through the T-coil, the package 1A, the PCB 1B, the connector 1C, the PCB 1E, the package 1D and the T-coil. The ESD component is equivalent to a larger capacitor, and the T-coil is electrically connected with the ESD component and may provide a inductance for impedance matching. In addition, the aforementioned ratio design of the conductive layer may be applied to the package 1A, the PCB 1B, the package 1D, the PCB 1E, etc.

In summary, the embodiment of the present invention provides a semiconductor device. The semiconductor device includes at least two conductive layers, wherein at least one of the conductive layers includes a grounding net and at least one signal ball-pad, and the grounding net has at least one ground void in the signal ball-pad is disposed. The signal ball-pad has a ball-pad diameter, the ground void has a ground void diameter, and a ratio of the ground void diameter to the ball-pad diameter is equal to or greater than 1.2. As a result, the capacitance between the signal ball-pad and the grounding net may be reduced for increasing the impedance and impedance continuity.

**Claims**

1. A semiconductor device (100), **characterized in that** the semiconductor device (100) comprises:

a first conductive layer (110, 210), and
a second conductive layer (120) disposed opposite to the first conductive layer (110, 210);
wherein the first conductive layer (110, 210) comprises:

a first grounding net (111, 211) having a first ground void (1111, 2111, 2111'); and
a first signal ball-pad (112, 112') in the first ground void (1111, 2111, 2111');

**characterized in that**
the first signal ball-pad (112, 112') has a first ball-pad diameter (112D), the first ground void (1111, 2111, 2111') has a first ground void diameter, and a ratio of the first ground void diameter to the first ball-pad diameter (112D) is equal to or greater than 1.2.

2. The semiconductor device according to claim 1, **characterized in that** the first conductive layer (110, 210) is a bottom layer, the first signal ball-pad (112, 112') of the bottom layer is configured for connecting a contact.

3. The semiconductor device according to claim 1 or claim 2, **characterized in that** the first conductive layer (110, 210) comprises:
a first signal via-pad (113) within the first ground void (1111, 2111, 2111');
wherein the first ground void (1111, 2111, 2111') has a second ground void diameter (1112D), the first signal via-pad (113) has a first via-pad diameter (113D), and a ratio of the second ground void diameter (1112D) to the first via-pad diameter (113D) is equal to or greater than 1.2.

4. The semiconductor device according to any one of the preceding claims, **characterized in that** the second conductive layer (120) is disposed above the first conductive layer (110, 210), the second conductive layer (120) comprises:

a second grounding net (121) having a second ground void (1211); and
a second signal via-pad (122) within the second ground void (1211);

wherein the second ground void (1211) has a third ground void diameter (1211D), the second signal via-pad (122) has a second via-pad diameter (122D), and a ratio of the third ground void diameter (1211D) to the second via-pad diameter (122D) is equal to or greater than 1.2.

5. The semiconductor device according to claim 3, **characterized in that** the first ball-pad diameter (112D) is greater than the first via-pad diameter (113D).

6. The semiconductor device according to claim 4, **characterized in that** the first signal ball-pad (112, 112') at least partially overlaps the second ground void (1211) in a stack direction of the first conductive layer (110, 210) and the second conductive layer (120).

7. The semiconductor device according to claim 4 or claim 5, **characterized in that** the second ground void diameter (1112D) is greater than the first ball-pad diameter (112D).

8. The semiconductor device according to any one of the preceding claims, **characterized in that** the first grounding net (111, 211) has a boundary (211e), the first ground void (1111, 2111, 2111') extends to the boundary (211e) to form an opening (211a, 211a'), and the opening (211a, 211a') exposes the first signal ball-pad (112, 112').

9. The semiconductor device according to claim 8, **characterized in that** there is a first connection line (L1, L1') of a center (112C, 112C') of the first signal ball-pad (112, 112') and a first edge (211a1, 211a1') of the opening (211a, 211a'), and there is a second connection line (L2, L2') of the center (112C, 112C') of the first signal ball-pad (112, 112') and a second edge (211a2, 211a2') of the opening (211a, 211a'), wherein an angle (A1, A1') included between the first connection line (L1, L1') and the second connection line (L2, L2') is equal to or greater than 60 degrees.

**Patentansprüche**

1. Halbleiteranordnung (100), **dadurch gekennzeichnet, dass** die Halbleiteranordnung (100) Folgendes umfasst:

   eine erste leitfähige Schicht (110, 210), und
   eine zweite leitfähige Schicht (120), die gegenüberliegend zu der ersten leitfähigen Schicht (110, 210) angeordnet ist;
   wobei die erste leitfähige Schicht (110, 210) Folgendes umfasst:

   ein erstes Massenetz (111, 211), das eine erste Masseaussparung (1111, 2111, 2111') aufweist; und
   ein erstes Signal-Ball-Pad (112, 112') in der ersten Masseaussparung (1111, 2111, 2111');

   **dadurch gekennzeichnet, dass** das erste Signal-Ball-Pad (112, 112') einen ersten Ball-Pad-Durchmesser (112D) aufweist, die erste Masseaussparung (1111, 2111, 2111') einen ersten Masseaussparungsdurchmesser aufweist, und ein Verhältnis des ersten Masseaussparungsdurchmessers zu dem ersten Ball-Pad-Durchmesser (112D) gleich oder größer als 1,2 ist.

2. Halbleiteranordnung nach Anspruch 1, **dadurch gekennzeichnet, dass** die erste leitfähige Schicht (110, 210) eine unterste Schicht ist, das erste Signal-Ball-Pad (112, 112') der untersten Schicht zum Verbinden eines Kontakts ausgebildet ist.

3. Halbleiteranordnung nach Anspruch 1 oder Anspruch 2, **dadurch gekennzeichnet, dass** die erste leitfähige Schicht (110, 210) Folgendes umfasst:
   ein erstes Signal-Kontaktloch-Pad (113) innerhalb der ersten Masseaussparung (1111, 2111, 2111');
   wobei die erste Masseaussparung (1111, 2111, 2111') einen zweiten Masseaussparungsdurchmesser (1112D) aufweist, das erste Signal-Kontaktloch-Pad (113) einen ersten Kontaktloch-Pad-Durchmesser (113D) aufweist, und ein Verhältnis des zweiten Masseaussparungsdurchmessers (1112D) zu dem ersten Kontaktloch-Pad-Durchmesser (113D) gleich oder größer als 1,2 ist.

4. Halbleiteranordnung nach einem der vorstehenden Ansprüche, **dadurch gekennzeichnet, dass** die zweite leitfähige Schicht (120) über der ersten leitfähigen Schicht (110, 210) angeordnet ist, die zweite leitfähige Schicht (120) Folgendes umfasst:

   ein zweites Massenetz (121), das eine zweite Masseaussparung (1211) aufweist; und
   ein zweites Signal-Kontaktloch-Pad (122) innerhalb der zweiten Masseaussparung (1211);

   wobei die zweite Masseaussparung (1211) einen dritten Masseaussparungsdurchmesser (1211D) aufweist, das zweite Signal-Kontaktloch-Pad (122) einen zweiten Kontaktloch-Pad-Durchmesser (122D) aufweist, und ein Verhältnis des dritten Masseaussparungsdurchmessers (1211D) zu dem zweiten Kontaktloch-Pad-Durchmesser (122D) gleich oder größer als 1,2 ist.

5. Halbleiteranordnung nach Anspruch 3, **dadurch gekennzeichnet, dass** der erste Ball-Pad-Durchmesser (112D) größer als der erste Kontaktloch-Pad-Durchmesser (113D) ist.

6. Halbleiteranordnung nach Anspruch 4, **dadurch gekennzeichnet, dass** das erste Signal-Ball-Pad (112, 112') die zweite Masseaussparung (1211) in einer Stapelrichtung der ersten leitfähigen Schicht (110, 210) und der zweiten leitfähigen Schicht (120) zumindest teilweise überlappt.

7. Halbleiteranordnung nach Anspruch 4 oder Anspruch 5, **dadurch gekennzeichnet, dass** der zweite Masseaussparungsdurchmesser (1112D) größer als der erste Ball-Pad-Durchmesser (112D) ist.

8. Halbleiteranordnung nach einem der vorstehenden Ansprüche, **dadurch gekennzeichnet, dass** das erste Massenetz (111, 211) eine Begrenzung (211e) aufweist, die erste Masseaussparung (1111, 2111, 2111') sich bis zu der Begrenzung (211e) erstreckt, um eine Öffnung (211a, 211a') zu bilden, und die Öffnung (211a, 211a') das erste Signal-Ball-Pad (112, 112') freilegt.

9. Halbleiteranordnung nach Anspruch 8, **dadurch gekennzeichnet, dass** es eine erste Verbindungslinie (L1, L1') zwischen einem Mittelpunkt (112C, 112C') des ersten Signal-Ball-Pads (112, 112') und einer ersten Kante (211a1,

# EP 4 528 814 B1

211a1') der Öffnung (211a, 211a') gibt, und es eine zweite Verbindungslinie (L2, L2') zwischen dem Mittelpunkt (112C, 112C') des ersten Signal-Ball-Pads (112, 112') und einer zweiten Kante (211a2, 211a2') der Öffnung (211a, 211a') gibt, wobei ein Winkel (A1, A1'), der zwischen der ersten Verbindungslinie (L1, L1') und der zweiten Verbindungslinie (L2, L2') eingeschlossen ist, gleich oder größer als 60 Grad ist.

## Revendications

1.  Dispositif semi-conducteur (100), **caractérisé en ce que** le dispositif semi-conducteur (100) comprend :

    une première couche conductrice (110, 210), et
    une deuxième couche conductrice (120) disposée à l'opposé de la première couche conductrice (110, 210) ;
    dans lequel la première couche conductrice (110, 210) comprend :

      un premier réseau de masse (111, 211) présentant une première cavité de masse (1111, 2111, 2111') ; et
      une première pastille de bille de signal (112, 112') dans la première cavité de masse (1111, 2111, 2111') ;

      **caractérisé en ce que**
      la première pastille de bille de signal (112, 112') présente un premier diamètre (112D) de pastille de bille de signal, la première cavité de masse (1111, 2111, 2111') présente un premier diamètre de cavité de masse, et un rapport du premier diamètre de cavité de masse au premier diamètre (112D) de pastille de bille de signal est égal ou supérieur à 1,2.

2.  Dispositif semi-conducteur selon la revendication 1, **caractérisé en ce que** la première couche conductrice (110, 210) est une couche inférieure, la première pastille de bille de signal (112, 112') de la couche inférieure est configurée pour connecter un contact.

3.  Dispositif semi-conducteur selon la revendication 1 ou la revendication 2, **caractérisé en ce que** la première couche conductrice (110, 210) comprend :
    une première pastille de via de signal (113) à l'intérieur de la première cavité de masse (1111, 2111, 2111') ;
    dans lequel la première cavité de masse (1111, 2111, 2111') présente un deuxième diamètre (1112D) de cavité de masse, la première pastille de via de signal (113) présente un premier diamètre (113D) de pastille de via de signal, et un rapport du deuxième diamètre (1112D) de cavité de masse au premier diamètre (113D) de pastille de via de signal est égal ou supérieur à 1,2.

4.  Dispositif semi-conducteur selon l'une quelconque des revendications précédentes,

    **caractérisé en ce que** la deuxième couche conductrice (120) est disposée au-dessus de la première couche conductrice (110, 210), la deuxième couche conductrice (120) comprend :

      un deuxième réseau de masse (121), présentant une deuxième cavité de masse (1211) ; et
      une deuxième pastille de via de signal (122), à l'intérieur de la deuxième cavité de masse (1211) ;

      dans lequel la deuxième cavité de masse (1211) présente un troisième diamètre (1211D) de cavité de masse, la deuxième pastille de via de signal (122) présente un deuxième diamètre (122D) de pastille de via de signal, et un rapport du troisième diamètre (1211D) de cavité de masse au deuxième diamètre (122D) de pastille de via de signal est égal ou supérieur à 1,2.

5.  Dispositif semi-conducteur selon la revendication 3, **caractérisé en ce que** le premier diamètre (112D) de pastille de bille de signal est supérieur au premier diamètre (113D) de pastille de via de signal.

6.  Dispositif semi-conducteur selon la revendication 4, **caractérisé en ce que** la première pastille de bille de signal (112, 112') recouvre au moins partiellement la deuxième cavité de masse (1211) dans une direction d'empilement de la première couche conductrice (110, 210) et de la deuxième couche conductrice (120).

7.  Dispositif semi-conducteur selon la revendication 4 ou la revendication 5, **caractérisé en ce que** le deuxième diamètre (1112D) de cavité de masse est supérieur au premier diamètre (112D) de pastille de bille de signal.

8. Dispositif semi-conducteur selon l'une quelconque des revendications précédentes, **caractérisé en ce que** le premier réseau de masse (111, 211) présente une limite (211e), la première cavité de masse (1111, 2111, 2111') s'étend jusqu'à la limite (211e) de manière à former une ouverture (211a, 211a'), et l'ouverture (211a, 211a') expose la première pastille de bille de signal (112, 112').

9. Dispositif semi-conducteur selon la revendication 8, **caractérisé en ce qu'**il existe une première ligne de liaison (L1, L1') entre le centre (112C, 112C') de la première pastille de bille de signal (112, 112') et un premier bord (211a1, 211a1') de l'ouverture (211a, 211a'), et il existe une deuxième ligne de liaison (L2, L2') entre le centre (112C, 112C') de la première pastille de bille de signal (112, 112') et un deuxième bord (211a2, 211a2') de l'ouverture (211a, 211a'), dans lequel un angle (A1, A1') inclus entre la première ligne de liaison (L1, L1') et la deuxième ligne de liaison (L2, L2') est égal ou supérieur à 60 degrés.

FIG. 1

FIG. 2A

FIG. 2B

FIG. 2C

FIG. 2D

FIG. 2E

FIG. 3

FIG. 4

EP 4 528 814 B1

FIG. 5

FIG. 6A

FIG. 6B

FIG. 7

**FIG. 8**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2023170290 A
- US 2011248800 A